(19) Europäisches Patentamt
European Patent Office
Office européen des brevets

(11) EP 3 706 170 A1

(12) EUROPEAN PATENT APPLICATION
published in accordance with Art. 153(4) EPC

(43) Date of publication:
09.09.2020 Bulletin 2020/37

(51) Int Cl.:
H01L 27/146 (2006.01)   G01S 7/486 (2020.01)
G01S 17/89 (2020.01)   H01L 31/10 (2006.01)
H04N 5/33 (2006.01)   H04N 5/369 (2011.01)
H04N 5/374 (2011.01)

(21) Application number: 18873423.0

(22) Date of filing: 18.09.2018

(86) International application number:
PCT/JP2018/034393

(87) International publication number:
WO 2019/087596 (09.05.2019 Gazette 2019/19)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 31.10.2017 JP 2017209979

(71) Applicant: Stanley Electric Co., Ltd.
Meguro-ku
Tokyo 153-8636 (JP)

(72) Inventors:
• MIYAZAKI, Tetsuo
  Tokyo 153-8636 (JP)
• GOTO, Hiroshige
  Tokyo 153-8636 (JP)

(74) Representative: Carstens, Dirk Wilhelm
Wagner & Geyer Partnerschaft mbB
Patent- und Rechtsanwälte
Gewürzmühlstraße 5
80538 München (DE)

(54) **IMAGE PICKUP DEVICE AND IMAGE PICKUP ELEMENT**

(57) An imaging device (1) includes a control device (5) and an image sensor (400) having a plurality of photodiodes. Each photodiode includes a p-epi (112) commonly formed to the plural photodiodes, an n-type semiconductor region (112) separated from an adjacent photodiode by a channel stopper (115), a p + region (123) covering the n-type semiconductor region (112) in contact with the channel stopper (115), and an internal electrode layer (113) interposed between the p-epi (112) and the n-type semiconductor region (112). The control device (5) supplies GND (=OV) and Vsub of a negative voltage to the channel stopper (115) and the p-epi (112), respectively.

FIG.7B

## Description

Technical Field

The present invention relates to an imaging device and an image sensor used for distance measurement.

Background Art

There has been known an imaging device which performs distance measurement by a TOF (Time Of Flight: Light Flight Time) method using an image sensor. In such an imaging device, the time required for modulated light to be reflected on an object within an imaging range and returned to each pixel after emitting the modulated light to the imaging range is measured for each pixel. The distance to each object within the imaging range is measured for each pixel on the basis of the measured time.

As the modulated light, infrared light may be used instead of visible light. As an advantage of the modulated light using the infrared light, first, the reflected light of infrared light is easily detectable from the incident light to the image sensor since background light is almost visible light. Secondly, the infrared light gives less uneasy feeling to people even when it is irradiated to people than the visible light.

Patent Literature 1 discloses an image sensor having a structure which is advantageous for performing distance measurement by a TOF method using near infrared light. The image sensor includes an epitaxial layer in a charge generation region, a (front) surface embedded region directly on the epitaxial layer (on the surface side), and an insulating film further on the surface side of the surface embedded region. A central light receiving gate electrode and first and second transfer gate electrodes lying on both sides thereof are provided on the surface side of the insulating film. When negative and positive voltages are applied to the first and second transfer gate electrodes respectively, a signal charge is transferred to an n-type first floating drain region. Also, when positive and negative voltages are applied to the first and second transfer gate electrodes respectively, a signal charge is transferred to an n-type second floating drain region. Since this signal charge is transferred to the first and second floating drain regions through the epitaxial layer at a position deep from the surface, the annihilation of the signal charge at its transfer due to the near infrared light can be suppressed.

Patent Literature 2 discloses a photoelectric conversion device which applies a reverse bias to a photodiode. In the photoelectric conversion device, an opening is formed in a central portion of an upper semiconductor region of semiconductor regions of two layers constituting the photodiode. Then, a central portion of the lower semiconductor region is exposed to the opening, and a wiring for reverse bias application is connected to the exposed portion. With the application of the reverse bias, the lower semiconductor region is fully depleted and its capacity is reduced.

Citation List

Patent Literatures

Patent Literature 1: WO 2007/026777A1
Patent Literature 2: JP P2000-312024A

Summary of Invention

Technical Problem

Since the infrared light is longer in wavelength than the visible light, the position of generation of the photoelectric effect by the infrared light becomes a position deep from the light receiving surface (the surface on the light receiving side of the image sensor). Since the conventional image sensor is often manufactured for the visible light, the generation position of the photoelectric effect of the infrared light may be outside the depletion layer of the photodiode. One of the positive and negative charges generated outside the depletion layer enters into the depletion layer through diffusion and then starts to drift due to the electric field of the depletion layer. There is a problem that since a diffusion rate is slow, the whole moving speed until the charge reaches the corresponding semiconductor region becomes slow, and hence a shutter speed (the number of times of distance measurement per unit time) is slow. Further, there is also a problem that being slow in the diffusion rate increases a possibility that one charge will recombine with the other charge during diffusion, and reduces the collected amount of signal charges to lower the sensitivity.

The imaging device of Patent Literature 1 relates to an improvement in transferring the signal charges generated and collected by the photoelectric effect from the photodiode to the storage unit, and does not improve the collection speed and the collected amount of signal charges in the photodiode before the storage of the signal charges.

Although the photoelectric conversion device of Patent Literature 2 applies the reverse bias to the photodiode, a region for potential setting is formed at the center of the upper semiconductor region for the application of the reverse bias. This means that since the region for the potential setting does not contribute to light reception, a light receiving area is reduced. Further, when the lower semiconductor region is thick, no reverse bias is applied over the entire thickness of the lower semiconductor region. As a result, the depth of the depletion layer cannot be sufficiently increased.

Incidentally, the application of a voltage from the outside to both surfaces of the epitaxial layer of the image sensor causes an increase in power consumption. The power consumption can be suppressed by lowering the concentration of donor or acceptor in the epitaxial layer to increase the resistance. However, even in such a case, since the uniformity of the donor or acceptor needs to be maintained, a wafer is made high in price, and the image sensor becomes expensive.

An object of the present invention is to provide an imaging device capable of efficiently collecting charges, generated by a photoelectric effect at a deep position from a light receiving surface, in a shallow semiconductor region with low power consumption.

Solution to Problem

In one aspect of the present invention, an imaging device includes: an image sensor having a plurality of photodiodes; and a control device which controls the image sensor. The imaging device includes:

a first semiconductor region of a first conductivity type formed commonly to the plurality of photodiodes,

a second semiconductor region which is separated from an adjacent photodiode by a channel stopper of the first conductivity type formed commonly to the plurality of photodiodes and is formed on the front surface side of the first semiconductor region, and which is a second conductivity type opposite to the first conductivity type;

a third semiconductor region of the first conductivity type formed to be in contact with the channel stopper and cover the front surface of the second semiconductor region;

a fourth semiconductor region of the first conductivity type which is interposed between the front surface side of the first semiconductor region and the back surface side of the second semiconductor region and in contact with the channel stopper, and has a higher impurity concentration than the first semiconductor region;

a first potential setting means which sets a potential to be applied to the back surface of the first semiconductor region; and

a second potential setting means which sets a potential to be applied to the fourth semiconductor region from the front surface side of the channel stopper.

The control device supplies a voltage to the first potential setting means and the second potential setting means to generate an acceleration electric field which accelerates and moves an electric charge of the second conductivity type present in the first semiconductor region in a direction from the back surface of the first semiconductor region to the fourth semiconductor region.

According to this aspect, even if the electric charge of the second conductivity type as the second conductivity type charge is generated by a photoelectric effect at a position deep from a light receiving surface, the electric charge is accelerated by the acceleration electric field and moved to the second semiconductor region at high speed. As a result, recombination between the electric charge of the second conductivity type and the electric charge of the first conductivity type is suppressed, and the electric charge of the second conductivity type can be efficiently collected in the second semiconductor region.

According to this aspect, a voltage difference which generates the acceleration electric field for accelerating the electric charge of the second conductivity type in the first semiconductor region is generated between the back surface of the first semiconductor region and the fourth semiconductor region. The fourth semiconductor region is in contact with the channel stopper electrically connected in parallel to the second semiconductor region. As a result, since the electric charge of the first conductivity type flows through the fourth semiconductor region via the channel stopper whose resistance value is lower than that of the second semiconductor region, power consumption for generating the acceleration electric field can be suppressed.

In another aspect of the present invention, each of the plurality of photodiodes further includes:

a fifth semiconductor region of the second conductivity type formed, away from the second semiconductor region, on the side opposite to the channel stopper side of the second semiconductor region; and

a gate formed between the second semiconductor region and the fifth semiconductor region.

The back surface of the second semiconductor region is in contact with the fourth semiconductor region on the channel stopper side and the first semiconductor region on the fifth semiconductor region side.

According to this another aspect, in the second semiconductor region, an electric field in a direction from the fourth semiconductor region side to the fifth semiconductor region side is generated due to a difference in the concentration impurities between the fourth semiconductor region and the first semiconductor region. Then, the electric field in the direction acts on the electric charge of the second conductivity type in the second semiconductor region so as to be accelerated toward the fifth semiconductor region. Thus, the moving speed of the electric charge of the second conductivity type from the second semiconductor region to the fifth semiconductor region when the gate is turned on is increased to make it possible to shorten the time required for the movement of the electric charge of the second conductivity type from the second semiconductor region to the fifth semiconductor region.

In another aspect of the present invention, the third semiconductor region is higher in impurity concentration than the channel stopper and the first semiconductor region and is smaller in thickness than the second semiconductor region.

According to this aspect, it is possible to effectively suppress a dark current and an afterimage by the third semiconductor region.

In another aspect of the present invention, the image sensor has the front surface side of the second semiconductor region as a light receiving side.

In the image sensor of the imaging device, there are two cases where the light receiving side (light reception side) is taken as the front surface side (FSI: Front Side Illumination), and it is taken as the back surface side (BSI: Back Side Illumination). According to this another aspect, the image sensor is taken as FSI. As a result, since the distance between the light receiving surface and the depletion layer can be shortened, the electric charge generated at a position shallow from the light receiving surface can be properly taken into the depletion layer.

In another aspect of the present invention, the image sensor has the back surface side of the first semiconductor region as a light receiving side.

According to this aspect, the image sensor is defined as BSI. This means that the second semiconductor is deep from the light receiving surface. As a result, the electric charge of the second conductivity type generated deeply from the light receiving surface can soon arrive at the second semiconductor region.

In another aspect of the present invention, the image sensor has a semiconductor substrate layer of a first conductivity type formed commonly to a plurality of photodiodes. The first semiconductor region is an epitaxial layer formed on the front surface side of the semiconductor substrate layer.

According to this aspect, the epitaxial layer as the first semiconductor region can be formed smoothly.

In another aspect of the present invention, the epitaxial layer has an impurity concentration to avoid the depletion layers of adjacent photodiodes overlapping each other upon generation of the acceleration electric field.

According to this aspect, it is possible to suppress power consumption in the first semiconductor region without crosstalk between adjacent pixels.

In another aspect of the present invention, the electric charge of the second conductivity type is an electron.

According to this aspect, a light reception amount can be measured based on the number of generated electrons.

In one aspect of the invention, an image sensor having a plurality of photodiodes. Each of the plurality of photodiodes includes:

a first semiconductor region of a first conductivity type formed commonly to the plurality of photodiodes;
a second semiconductor region which is separated from an adjacent photodiode by a channel stopper of the first conductivity type formed commonly to the plurality of photodiodes and is formed on the front surface side of the first semiconductor region, and which is a second conductivity type opposite to the first conductivity type;
a third semiconductor region of the first conductivity type formed so as to be in contact with the channel stopper and cover the front surface of the second semiconductor region;
a fourth semiconductor region of the first conductivity type which is interposed between the front surface side of the first semiconductor region and the back surface side of the second semiconductor region, is in contact with the channel stopper, and has a higher impurity concentration than the first semiconductor region;
a first potential setting means to which a first potential is supplied, the first potential being applied to the back surface of the first semiconductor region; and
a second potential setting means to which a second potential is supplied, the second potential being applied to the fourth semiconductor region from the front surface side of the channel stopper.

According to the one aspect of the present invention, an electric charge of the second conductivity type in the first semiconductor region can be accelerated by an acceleration electric field generated between the back surface of the first semiconductor region and the fourth semiconductor region, and collected in the second semiconductor region.

According to the present invention, a voltage difference which generates the acceleration electric field is applied between the fourth semiconductor region on the back surface side of the second semiconductor region and the back surface of the first semiconductor region. The fourth semiconductor region is in contact with the channel stopper electrically connected in parallel to the second semiconductor region. As a result, since an electric charge of the first conductivity type flows through the fourth semiconductor region via the channel stopper whose resistance value is lower than that of the second semiconductor region, power consumption for generating the acceleration electric field can be suppressed.

In another aspect of the present invention, each of the plurality of photodiodes further includes:

a fifth semiconductor region of the second conductivity type formed, away from the second semiconductor region, on the side opposite to the channel stopper side of the second semiconductor region; and
a gate formed between the second semiconductor region and the fifth semiconductor region, and
wherein the back surface of the second semiconductor region is in contact with the fourth semiconductor region on the channel stopper side and the first semiconductor region on the fifth semiconductor region side.

According to this another aspect, an acceleration electric field in a direction from the channel stopper side to the fifth semiconductor region side is generated in the in the second semiconductor region. Thus, the moving speed of the electric charge of the second conductivity type from the second semiconductor region to the fifth semiconductor region when the gate is turned on is increased to make it possible to shorten the time required for the movement.

Brief Description of Drawings

FIG. 1 is an overall configuration diagram of an imaging device.
FIG. 2 is a configuration diagram of an image sensor included in a camera.
FIG. 3 is a detailed configuration diagram of a pixel.
FIG. 4 is a timing chart of outgoing modulated light and reflection modulated light.
FIG. 5A is a cross-sectional view taken when sub-pixels of the image sensor of FIG. 2 are cut along a column direction of a pixel array portion.
FIG. 5B is a cross-sectional view taken when sub-pixels of an image sensor of a comparative example are cut along a column direction of a pixel array portion.
FIG. 6A is a cross-sectional view taken when the sub-pixels of the image sensor of FIG. 2 are cut along a row direction of the pixel array portion.
FIG. 6B is a cross-sectional view taken when sub-pixels of an image sensor of a comparative example are cut along a row direction of a pixel array portion.
FIG. 7A is a diagram showing an acceleration electric field generated when the amount of projection of a covering portion in an internal electrode layer is large.
FIG. 7B is a diagram showing an acceleration electric field generated when the amount of projection of the covering portion in the internal electrode layer is small.
FIG. 8A is a connection diagram of an image sensor and a voltage source.
FIG. 8B is an equivalent circuit diagram of FIG. 8A about a positive hole current.
FIG. 8C is an equivalent circuit diagram about a positive hole current when an internal electrode layer does not exist.
FIG. 9A is a cross-sectional view of sub-pixels when cut along a vertical direction in an example of application to a BSI type image sensor.
FIG. 9B is a cross-sectional view of the sub-pixels when cut along a horizontal direction in the example of application to the BSI type image sensor.

Description of Embodiments

[Whole of imaging device]

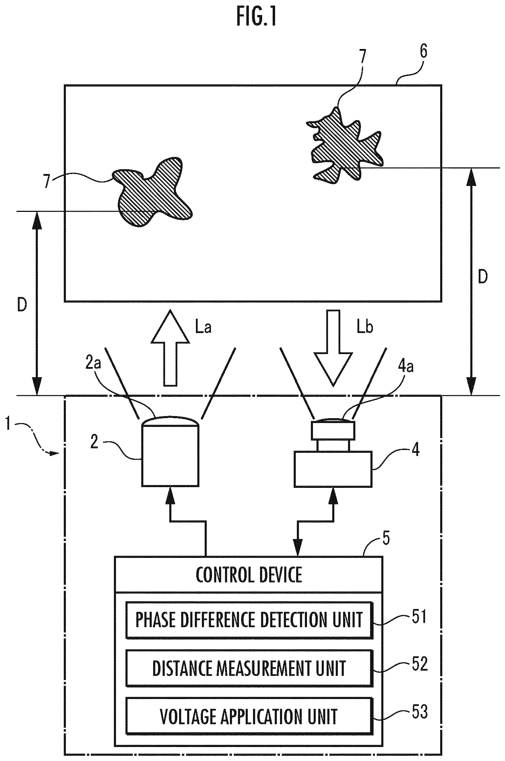

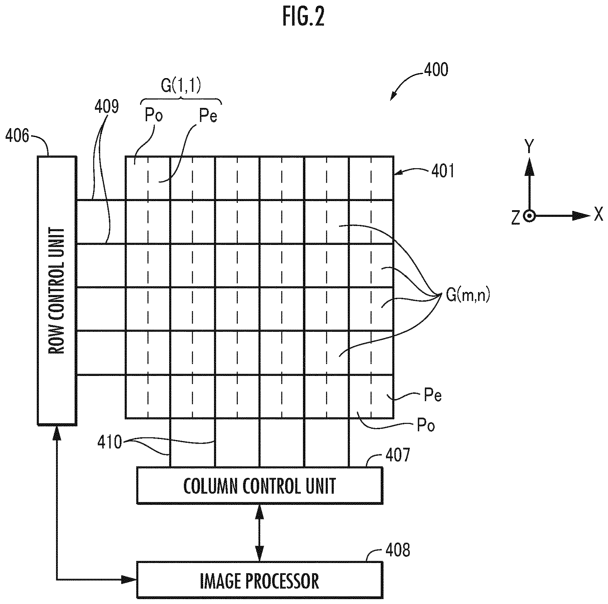

FIG. 1 is an overall configuration diagram of an imaging device 1. The imaging device 1 includes a modulated light outgoing unit 2, a camera 4, and a control device 5, and measures for each pixel G (FIG. 2), a distance D from the imaging device 1 to an object 7 to be ranged present in an imaging range 6 of the camera 4.

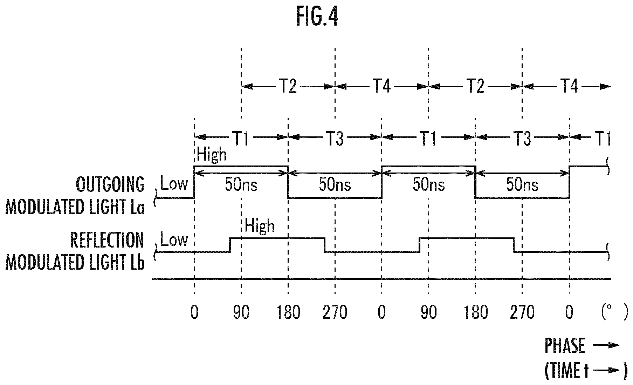

The modulated light outgoing unit 2 is controlled to be turned on and turned off by a control signal from the control device 5, and blinks at, for example, 10 MHz (FIG. 4) to generate modulated light whose intensity is modulated. The modulated light is adjusted for light distribution by a lens 2a mounted on a light outgoing portion of the modulated light outgoing unit 2 and emitted as an outgoing modulated light La. Thus, the outgoing modulated light La irradiates the entire imaging range 6 at a time. Near infrared light is used as the outgoing modulated light La.

When one or more ranging objects 7 exist in the imaging range 6, the outgoing modulated light La is reflected by the ranging object 7, and after its reflection, the outgoing modulated light La becomes reflection modulated light Lb derived from the outgoing modulated light La, which returns to the imaging device 1. The lens 4a is attached to an incident part of the camera 4, collects the light incident from the imaging range 6, and causes the light to be incident on an image sensor 400 (FIG. 2) in the camera 4 as captured image light. The captured image light includes background light and the reflection modulated light Lb. The reflection modulated light Lb is incident on the corresponding pixel G (FIG. 2) in the image sensor 400 according to the position occupied by the ranging object 7 derived therefrom in the imaging range 6.

The control device 5 includes a phase difference detection unit 51, a distance measurement unit 52, and a voltage application unit 53.

Since the details of processing in which the imaging device 1 measures the distance D to the ranging object 7 by a TOF method will be described later, the imaging device 1 will be schematically described here. The image sensor 400 (FIG. 2) of the camera 4 makes it possible to read an accumulated charge amount of an electric charge generated in relation to the intensity of the incident light for each pixel from the outside. Incidentally, the electric charge includes positive holes (holes) as a positive electric charge and electrons as a negative charge. In the imaging device 1, the amount of electricity corresponding to the number of electrons is stored as the accumulated charge amount of electric charge.

The phase difference detection unit 51 detects a phase difference $\phi$ between the outgoing modulated light La emitted from the modulated light outgoing unit 2 and the reflection modulated light Lb on the basis of the accumulated charge amount read from the image sensor 400 for each pixel. The distance measurement unit 52 measures the distance D based on the phase difference detected by the phase difference detection unit 51.

FIG. 2 is a configuration diagram of the image sensor 400 included in the camera 4. Incidentally, for convenience of the description of the structure of a pixel array unit 401 after FIG. 2, a three-axis orthogonal coordinate system is defined. A direction view in which a light receiving surface of the pixel array unit 401 can be viewed is assumed to be a front view, and a row direction and a column direction of a grid array of the pixels G in the pixel array unit 401 are respectively assumed to be an X axis direction and a Y axis direction in a front view. The positive direction of the X-axis is assumed to be from left to right in the front view of the pixel array unit 401, and the positive direction of the Y-axis is assumed to be from bottom to top in the front view of the pixel array unit 401. A Z axis is defined as a direction parallel to the thickness direction of the image sensor 400, and the positive direction of the Z axis is assumed to be from the back side to the front side of the image sensor 400.

The image sensor 400 includes the pixel array unit 401, a row control unit 406, a column control unit 407, and an image processor 408 as main components. Incidentally, the image sensor 400 is a CMOS type.

The pixel array unit 401 in FIG. 2 has a plurality of pixels G (m, n) distributed with uniform density longitudinally (direction of Y axis) and laterally (direction of X axis) in a lattice array on a plane in front view.

Incidentally, the pixel G in the pixel array unit 401 is expressed by a row number m and a column number n. The pixel G (m, n) is assumed to indicate a pixel G which is the m-th from the top in the front view of the pixel array unit 401 and is the n-th from the left. The pixel array unit 401 is comprised of, for example, 126 $\times$ 126 pixels G. Hereinafter, when it is not necessary to distinguish between the individual pixels in particular, the pixel G (m, n) is generically referred to as a pixel G, and (m, n) is omitted. Each pixel G has a left side sub-pixel Po and a right side sub-pixel Pe in the front view.

The row control unit 406 applies a control signal to a row control line 409 to enable the pixels G of the pixel array unit 401 to be controlled for each row. The column control unit 407 applies a control signal to a column control line 410 so that the pixels G of the pixel array unit 401 can be controlled for each column. The image processor 408 controls the row control unit 406 and the column control unit 407 based on the control signal (control voltage) from the control device 5 (FIG. 1).

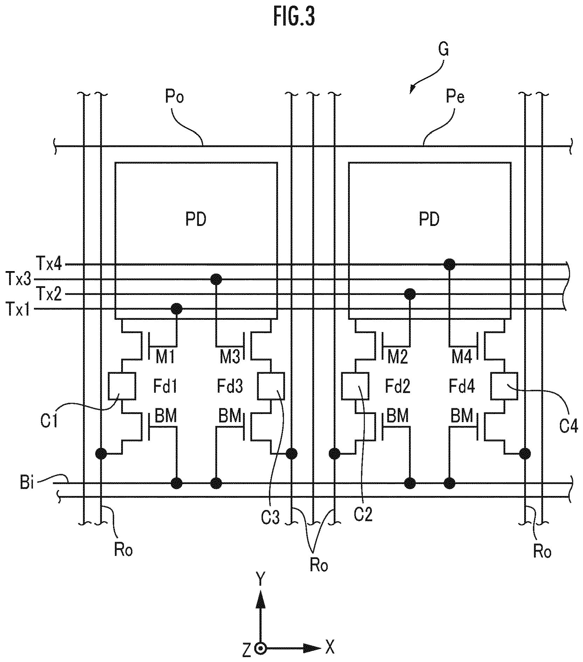

FIG. 3 is a detailed configuration diagram of the pixel G. The sub-pixel Po includes PD, M1, M3, Fd1, Fd3, and two BMs. The sub-pixel Pe includes PD, M2, M4, Fd2, Fd4, and two BMs. Incidentally, PD means a photodiode, M means a distribution switch, Fd means a floating diffusion as a charge storage portion, and BM means a transfer switch. M1 to M4 and BM are comprised of FETs (Field Effect Transistors).

Control signals for controlling on / off of M1 to M4 are supplied from the row control unit 406 to Tx1 to Tx4. A control signal for controlling on / off of the BM is supplied from the column control unit 407 to Bi. A set of Tx1 to Tx4 and Bi lines is included in each row control line 409 (FIG. 2).

Ro is connected to the drains of all the BMs of the corresponding column (in which each column of Fd1 to Fd4 is distinguished). The column control unit 407 reads C1 to C4 as readout values of charge amounts of electric charges accumulated in Fd1 to Fd4 of each pixel G via Ro. Ro is included in each column control line 410 (FIG. 2)

The sub-pixel Po and the sub-pixel Pe are the same in overall operation except that only the operation timings of M1 to M4 and BM as gates in the sub-pixel are different. Accordingly, only the operation of the sub-pixel Po will be described.

PD generates a larger number of electrons as the intensity of incident light (including background light and reflection modulated light Lb therein) incident on the pixel G increases. The amount of electric charge increases as the number of electrons increases. M1 and M3 are turned on and off in opposite phases by the voltages applied to Tx1 and Tx3. That is, an on period of M1 is taken as an off period of M3, and an off period of M1 is taken as an on period of M3. A blinking period of the modulated light outgoing unit 2, that is, an on/off cycle period of each of M1 and M2 is made sufficiently smaller than an on time interval of BM. Accordingly, each pixel G repeats the incidence of the reflection modulated light Lb a plurality of times during each off period of BM, so that a charge accumulation amount related to an incident intensity Ii of the reflection modulated light Lb can be increased for each of Fd1 to Fd4.

In the on period of each of M1 and M3, the electrons generated by PD are supplied to Fd1 and Fd3 and accumulated. Electric charges of charge amounts related to the intensity of the incident light incident on the pixel G (strictly speaking, the sub-pixel Po or Pe) are accumulated in Fd1 and Fd3. Ro is made conductive by the operation of the switch in the column control unit 407 at a predetermined read timing, and the charge amounts of Fd1 and Fd3 of the sub-pixel Po to which BM turned on at this time belongs are read as the read values C1 and C3 by the image processor 408 via the column control unit 407. C1 and C3 are further sent from the image processor 408 to the control device 5 (FIG. 1).

FIG. 4 is a timing chart of the outgoing modulated light La and the reflection modulated light Lb. The scale on the horizontal axis indicates a value representing a time lapse by the phase of the outgoing modulated light La. The outgoing modulated light La is the light emitted from the modulated light outgoing unit 2. The level of the outgoing modulated light La is Low when the modulated light outgoing unit 2 is off, and High when the modulated light outgoing unit 2 is on. The light intensity corresponding to the High level at the time of lighting is increased or decreased according to an increase or decrease in a feeding current of the modulated light outgoing unit 2.

The outgoing modulated light La is light of a periodic pulse waveform, and has a rectangular wave having a duty ratio = 50% at a cycle = 100 ns (frequency = 10 MHz). In FIG. 4, the rising time of the outgoing modulated light La is represented by phase = 0°. The reflection modulated light Lb is such that the outgoing modulated light La emitted from the imaging device 1 reaches the ranging object 7 (FIG. 1), is reflected by the ranging object 7, and returns to the imaging device 1. As a result, the phase of the reflection modulated light Lb is delayed in phase from the outgoing modulated light La by the time taken to fly twice the length of the distance D to the ranging object 7, and hence a phase difference $\phi$ occurs between the outgoing modulated light La and the reflection modulated light Lb. The distance D between the imaging device 1 and the ranging object 7 can be measured from the phase difference $\phi$.

As described above, the image processor 408 (FIG. 2) is capable of reading out the charge amounts of Fd1 to Fd4 for each pixel G via Bi and Ro. The image processor 408 is capable of reading out the accumulated charge amounts related to the incident intensity Ii of the reflection modulated light Lb incident on the pixel G from Fd1 to Fd4 of each pixel G. In FIG. 4, T1 to T4 indicate accumulation periods of charge amounts that the image processor 408 reads out from Fd1 to Fd4 in each pixel G, respectively.

Although the periods T1 to T4 are different in start phase, the length of the period is set equal to one half (= half period) of the period of the outgoing modulated light La. T1 is set to a period of phases 0° to 180°. T2 is set to a period of phases 90° to 270°. T3 is set to a period of phases 180° to 360°. T4 is set to a period of phases 270° to 360° and a period of phases 0° to 90° of the next cycle, in other words, a phase of phases 270° to 450°. As a result, electric charges are accumulated in Fd1 to Fd4 with charge amounts corresponding to the incident intensity Ii of the reflection modulated light Lb incident on the corresponding sub-pixels during T1 to T4. The image processor 408 reads out the charge amounts of the electric charges accumulated in T1 to T4 in each pixel G as read values C1 to C4.

The control device 5 calculates the phase difference $\phi$ by the following equation (1).

$$\text{Equation (1): phase difference } \phi = \tan^{-1}\{(C1 - C3)/(C2 - C4)\}$$

In the above equation, "tan" means a tangent, and "tan$^{-1}$" means an arctangent. Although each of C1 to C4 includes the accumulated charge amount due to the incident light derived from the background light, an influence due to the incident light derived from the background light is eliminated from the differences C1 - C3 and C2 - C4.

[Semiconductor structure of image sensor]

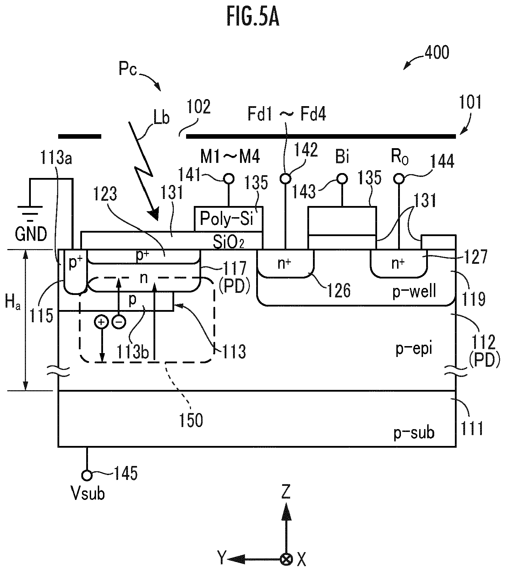

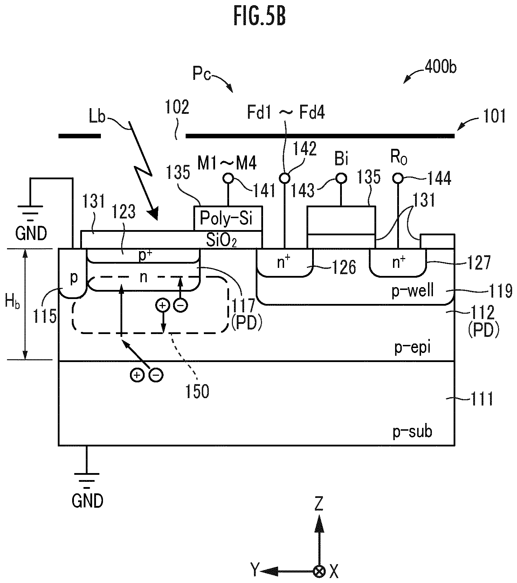

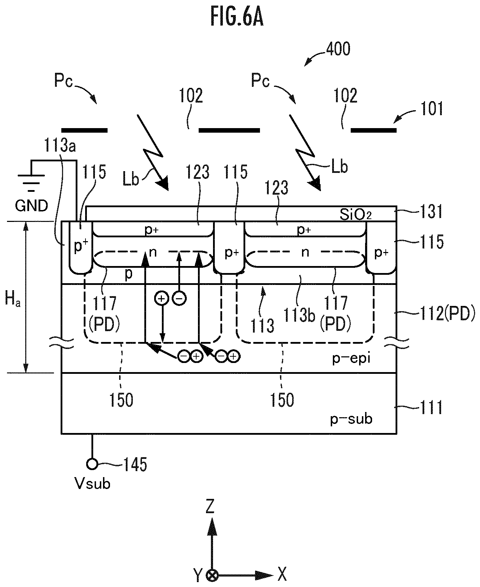

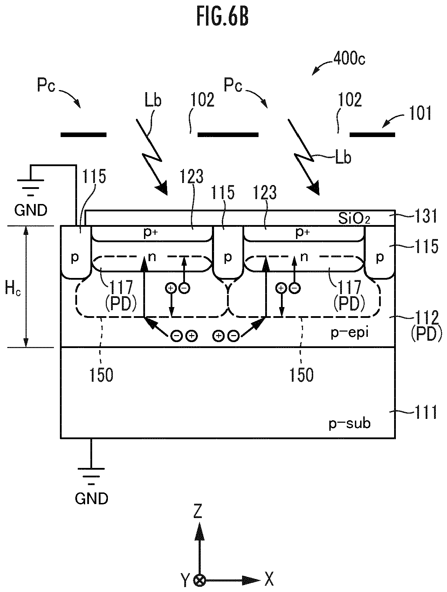

The structure of the image sensor 400 will be described with reference to FIG. 5A to FIG. 6B. Incidentally, in order to facilitate understanding of the structure of the image sensor 400, the image sensor 400 and an image sensor 400b of a comparative example are compared in FIG. 5A and FIG. 5B, and the image sensor 400 and an image sensor 400c are compared in FIG. 6A and FIG. 6B. In the image sensors 400b and 400c of the comparative examples, the elements corresponding to the elements of the image sensor 400 are given the same reference numerals as those attached to the elements of the image sensor 400. Further, the sub-pixel Pc is used as a generic name of the sub-pixels Po and Pe.

FIG. 5A and FIG. 5B are cross-sectional views when the sub-pixels Pc of the image sensors 400 and 400b are cut along the column direction (Y-axis direction) of the pixel array unit 401. The image sensor 400b is, for example, a conventional image sensor for visible light.

FIG. 6A and FIG. 6B are cross-sectional views when the sub-pixels Pc of the image sensors 400 and 400c are cut along the row direction (X-axis direction) of the pixel array unit 401. The image sensor 400c is, for example, an element (which is low in concentration) in which the impurity concentration of a p-epi (p-type epitaxial layer) 112 is reduced by a predetermined amount with respect to the image sensor 400b of FIG. 5B.

Although only one or two sub-pixels Pc are described in FIG. 5A to FIG. 6B for simplification of illustration respectively, the same cross-sectional structure as in FIG. 5A to FIG. 6B is made continuous by the total number of sub-pixels Pc in the column or row direction in the actual cross-section of the pixel array unit 401.

In the manufacture of a semiconductor, a new semiconductor region is stacked on the previously formed and manufactured semiconductor region. In each semiconductor layer, the surface on which a new semiconductor layer is stacked is defined as a "front surface", and the surface opposite to the front surface is defined as a "back surface". Incidentally, in the present specification, in order to distinguish between FSI (Front Side Illumination) and BSI (Back Side Illumination), the "front surface" and the "light receiving surface" are distinguished from each other, and the "back surface" and the "rear surface" are distinguished from each other.

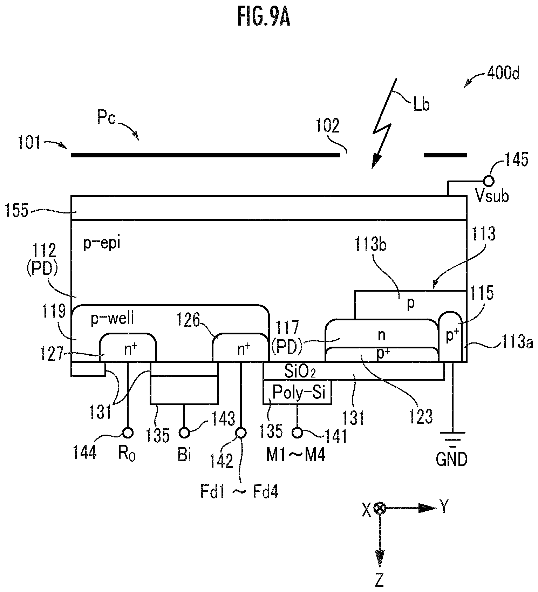

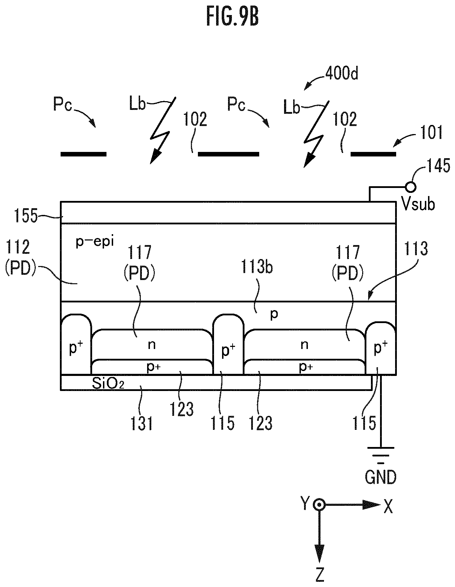

The image sensor 400 is of an FSI type. That is, the front surface side is taken as the light receiving side (light receiving surface side), and the back surface side is taken as the rear surface side. On the other hand, in a BSI type image sensor 400d in FIG. 9A and FIG. 9B to be described later, the front surface side is taken as the rear surface side, and the back surface side is taken as the light receiving side.

When the image sensor 400 is taken as the FSI type, the dimension in the Z-axis direction from the light receiving surface to a depletion layer 150 (FIG. 5A or the like) can be made shorter than when the image sensor 400 is taken as the BSI type. This is advantageous because the electric charge generated by a photoelectric effect at a position (shallow position) close to the light receiving surface can be taken into the depletion layer 150.

In FIG. 5A and FIG. 6A, a light shield 101 is disposed a predetermined length in the Z-axis direction away from the front surface of the pixel array unit 401 and covers the front surface of the pixel array unit 401 on the light receiving side (positive side in the Z-axis direction) of the image sensor 400. The light shield 101 has a window 102 of approximately the same size as the light receiving surface of the PD at a location facing the PD (the same photodiode as PD in FIG. 2) of each sub-pixel Pc.

Hereinafter, in the embodiment, a first conductivity type and a second conductivity type will be described as a p type and an n type, respectively. The first conductivity type and the second conductivity type are defined as mutually opposite conductivity types. Further, when the first conductivity type and the second conductivity type are made to correspond to the p-type and the n-type, respectively, the electric charge of the first conductivity type and the electric charge of the second conductivity type are made to correspond to positive holes and electrons, respectively. In the present invention, the first conductivity type and the second conductivity type may be taken as the n-type and the p-type, respectively, and the electric charge of the first conductivity type and the electric charge of the second conductivity type may be taken as electrons and positive holes, respectively.

The image sensor 400 has a p-sub (p-type semiconductor substrate layer) 111 and a p-epi 112 formed on the front surface side of the p-sub. The thickness of the p-epi 112, i.e., the dimension in the Z-axis direction is Ha.

An internal electrode layer 113(113a, 113b), a channel stopper 115, an n-type semiconductor region 117, a p-type well 119, a p + region 123, and n + regions 126 and 127 are formed on the front surface side of the p-epi 112. These are manufactured by a known ion implantation (Ion Implantation) method from the front surface side of the p-epi 112 in order from the bottom in their stacking direction (in order in the direction from the back surface to the front surface of the p-epi 112). The channel stopper 115 is manufactured by the ion implantation method after the manufacture of the internal electrode layer 113.

The back surface of the internal electrode layer 113 exists at a position (position on the negative side in the Z-axis direction) deeper than the back surface of the channel stopper 115 from the front surface of the p-epi 112. The back surface of the internal electrode layer 113b is exposed on the front surface of the p-epi 112. The channel stopper 115 is buried in the internal electrode layer 113.

In regard to a P-type impurity concentration, the p-epi 112, the channel stopper 115, and the internal electrode layer 113 continue in order from the low side. Although the impurity concentration of the p + region 123 is usually set higher than the impurity concentration of the channel stopper 115, it is not necessarily limited as long as the purpose of forming a photodiode is achieved. The impurity concentration of the p-type well 119 is higher than the impurity concentration of the p-epi 112. In regard to an n-type impurity concentration, the n + regions 126 and 127 are higher than the n-type semiconductor region 117. Needless to say, the higher the impurity concentration, the lower the resistance.

In the p-epi 112, the n-type semiconductor region 117 and the p-type well 119 are formed in different ranges in each sub-pixel Pc so as to be embedded from the front surface side. The range of the n-type semiconductor region 117 corresponds to a range occupied by PD in FIG. 3, and the range of the p-type well 119 corresponds to a range occupied by Fd1 and Fd3 (in the case where the sub-pixel Pc is the sub-pixel Po), etc.

The p-type channel stopper 115 functions as separation between pixels or separation between PDs, and is formed commonly to a plurality of PDs. The channel stopper 115 extends from the front surface side of the p-epi 112 to a depth further below the back surface of the n-type semiconductor region 117 (negative side in the Z-axis direction), and separates the n-type semiconductor region 117 and the p + region 123 from the adjacent sub-pixel Pc. The channel stoppers 115 are formed in a grid fashion so as to separate the boundary lines between the sub-pixels Pc, and surround each sub-pixel Pc by a rectangular frame in a front view of the pixel array unit 401.

The p + region 123 has a function of suppressing a dark current and an afterimage. Therefore, as mentioned above, the impurity concentration of the p + region 123 is higher than the impurity concentrations of the p-sub 111 and the channel stopper 115 of the same conductivity type. Further, the thickness (dimension in the Z-axis direction) of the p + region 123 is smaller than the thickness of the n-type semiconductor region 117.

An oxide film (silicon dioxide film) 131 covers the front surface of the sub-pixel Pc. However, the oxide film 131 is removed in the range of the internal electrode layer 113, the channel stopper 115, and the n + regions 126 and 127. The poly silicon film 135 is formed at a predetermined portion on the front surface side of the oxide film 131.

In FIG. 5A, M1 to M4, Fd1 to Fd4, Bi, and Ro are as described in FIG. 3. A connection point 141 is connected to any one of M1 to M4. A connection point 142 is connected to any one of Fd1 to Fd4. A connection point 143 is connected to Bi. A connection point 144 is connected to Ro.

The connection point 142 is connected to the n + region 126. The connection point 144 is connected to the n + region 127. A positive voltage applied to the connection point 141 is applied to the polysilicon film 135 connected with the connection point 141 to control an n channel between the n-type semiconductor region 117 and the n + region 126. A voltage applied to the connection point 143 is applied to the polysilicon film 135 to which the connection point 143 is connected, to control an n channel between the n + region 126 and the n + region 127.

A connection point 145 is connected to the back surface side of the p-sub 111 and is supplied with Vsub being a negative voltage from the voltage application unit 53 of the control device 5. The channel stopper 115 is supplied with GND (= 0V) from the voltage application unit 53 of the control device 5 to the front surface side. The potential of the n-type semiconductor region 117 is set such that a pn junction between the channel stopper 115 and the p + region 123 is in a reverse bias state. The p-sub 111 is held at Vsub as a negative potential by the supply of Vsub from the connection point 145. The connection point 145 and the front surface of the channel stopper 115 function as a first and a second potential setting means of this invention, respectively.

The p-epi 112 and the n-type semiconductor region 117 constitute one PD as a pair of an anode and a cathode respectively in each sub-pixel Pc. The depletion layer 150 is formed in a boundary region between the p-epi 112 and the n-type semiconductor region 117. The connection point 145 and the channel stopper 115 are supplied with Vsub and GND as mutually different voltages, so that the spread of the depletion layer also changes somewhat.

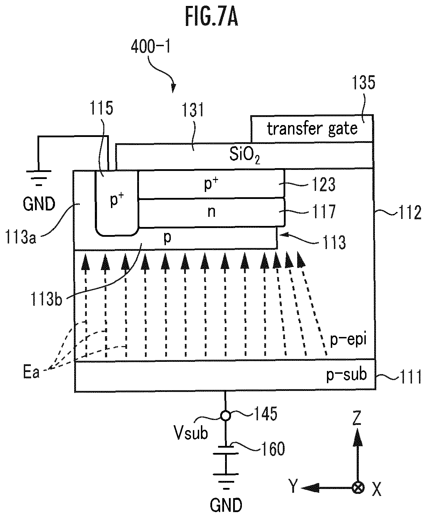

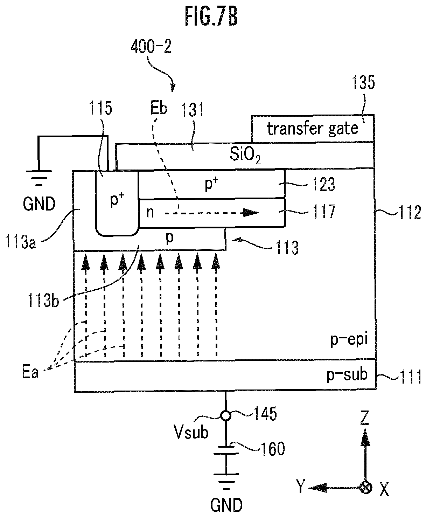

FIG. 7A and FIG. 7B relate to the description of acceleration electric fields in image sensors 400-1 and 400-2. A point of difference in structure between the image sensor 400-1 of FIG. 7A and the image sensor 400-2 of FIG. 7B is the length of a covering portion 113b of the internal electrode layer 113 in the Y-axis direction. That is, the length of the covering portion 113b in the Y-axis direction is shorter in the image sensor 400-2 than in the image sensor 400-1. The image sensors 400-1 and 400-2 are both embodiments of the image sensor 400. When both image sensors are not distinguished from each other, they are collectively referred to as the "image sensor 400".

The direction of electric lines of force is normally matched to the direction of the force acting on the positive electric charge, but in FIG. 7, the directions of the electric lines of force Ea and Eb are represented as the direction of the force acting on the electrons.

The internal electrode layer 113 has a hanging portion 113a extending from the front surface of the p-epi 112 to the back surface side of the p-epi 112, and a covering portion 113b interposed between the p-epi 112 and the back surface of the n-type semiconductor region 117 so as to cover the back surfaces of the channel stopper 115 and the n-type semiconductor region 117. The direction in which the hanging portion 113a extends is a direction parallel to the Z axis, and the direction in which the covering portion 113b spreads is a direction along the back surface of the n-type semiconductor region 117, i.e., a direction parallel to an XY plane including the X axis and the Y axis.

The GND is supplied to the internal electrode layer 113 or the channel stopper 115, and the internal electrode layer 113, the channel stopper 115, and the p + region 123 become GND. Thus, the covering portion 113b becomes a voltage of GND. On the other hand, the connection point 145 is supplied with Vsub of a negative voltage from a DC power supply 160 of the voltage application unit 53. Consequently, the entire back surface of the p-epi 112 becomes Vsub.

A voltage difference between the back surface of the covering portion 113b and the back surface of the p-epi 112 generates an electric field between the back surface of the covering portion 113b and the back surface of the p-epi 112. This electric field becomes an electric field which accelerates arbitrary electrons existing between the back surface of the covering portion 113b in the Z-axis direction and the back surface of the p-epi 112 in the Z-axis direction from the back surface of the p-epi 112 to the back surface of the covering portion 113b. Ea indicates electric lines of force included in the electric field. The direction of the electric lines of force normally takes the direction of the force acting on the positive electric charge, but in order to make the action easy to understand, the electric lines of force Ea and Eb are shown in the direction of acting on the electrons.

In the image sensor 400-1 of FIG. 7A, the covering portion 113b substantially covers the entire back surface of the n-type semiconductor region 117 from the back surface side of the n-type semiconductor region 117. On the other hand, in the image sensor 400-2 of FIG. 7B, the back surface of the n-type semiconductor region 117 is bisected in the Y-axis direction, and the covering portion 113b covers the back surface portion of only about half of the back surface of the n-type semiconductor region 117 on the channel stopper 115 side in the Y-axis direction. Accordingly, the back surface portion of the back surface of the n-type semiconductor region 117 opposite to the channel stopper 115 in the Y-axis direction is exposed not onto the internal electrode layer 113 but from the internal electrode layer 113 and in contact with the p-epi 112. An acceleration electric field which generates electric lines of force Ea is generated if the covering portion 113b covers at least a part of the back surface of the n-type semiconductor region 117.

The impurity concentration of the internal electrode layer 113 is higher than the impurity concentration of the p-epi 112. With this density difference, in the image sensor 400-2 of FIG. 7B, an electric line of force Eb as a force line acting on electrons is generated in the n-type semiconductor region 117 in the Y-axis direction. A polysilicon film 135 constituting one element of an electron transfer gate exists ahead in the direction of the direction of the electric line of force Eb, and an n + region 126 as a destination of electrons in the n-type semiconductor region 117 at the time of turning on of the polysilicon film 135 further exists ahead the polysilicon film 135.

Referring back to FIG. 5A to FIG. 6B, Ha is the thickness of the p-epi 112 (dimension in the Z-axis direction). Ha copes with reception of infrared light by the image sensor 400, and is set to a value sufficiently larger than the thickness Hb of the p-epi 112 of the image sensor 400b for visible light reception.

When light is incident on each PD of the image sensor 400, positive holes and electrons are generated in each PD from the light receiving surface at a depth position corresponding to the wavelength of the incident light by the photoelectric effect due to the incident light. If the generation position is in the depletion layer 150, the amount of charge collection increases, and the sensitivity of the image sensor 400 is improved.

As the absolute value of the negative voltage of Vsub is increased, the end face on the back surface side of the depletion layer 150 approaches the end face on the front surface side of the p-sub 111 and eventually reaches the end face on the front surface side of the p-sub 111. The depletion layer 150 at this time is called a "completely depleted state". Electrons generated over the entire region of the p-epi 112 can be collected in the n-type semiconductor region 117 by the acceleration electric field without being in the "completely depleted state".

Incidentally, the upper limit of the absolute value of Vsub is made equal to or less than a value that does not cause breakdown (break down: insulation breakdown) of the junction between the p-epi 112 and the n-type semiconductor region 117. For example, Vsub generally has a minimum value (note: for negative values, the larger the absolute value is the smaller), which becomes, for example, -12V. Since the wavelength of infrared light ranges from 830 to 960 nm, Vsub is set so that the length at which the depth from the light receiving surface of the PD to the lowermost surface of the depletion layer 150 is substantially equal to the wavelength of the infrared light is secured.

In FIG. 5B, only points of difference from the image sensor 400 will be described with respect to the image sensor 400b. The thickness Hb of the p-epi 112 is Hb<Ha with respect to the thickness Ha of the p-epi 112 in the image sensor 400. In the image sensor 400b, GND is supplied from the voltage application unit 53 of the control device 5 to both the p-sub 111 (the same voltage as Vsub) and the channel stopper 115. Since no electric field generating voltage is supplied to the image sensor 400b, the thickness of the depletion layer 150 is smaller than the thickness of the depletion layer 150 of the image sensor 400.

The image sensor 400 (FIG. 5A) and the image sensor 400b (FIG. 5B) are compared with each other. When the reflection modulated light Lb is infrared light, the wavelength of the reflection modulated light Lb is long. As a result, the photoelectric effect due to the incidence of the reflection modulated light Lb on the PD becomes likely to occur at a deep position from the light receiving surface of the PD. In FIG. 5A to FIG. 6B, + and - with circles indicate positive holes and electrons generated by the photoelectric effect, respectively. The positive holes and electrons occur in pairs.

When the position of generation of the photoelectric effect is in the depletion layer 150, the positive holes and electrons are drifted to the inside of the n-type semiconductor region 117 and the p-epi 112 outside the depletion layer 150 in the Z-axis direction by the electric field generated by the generation of the depletion layer 150. Incidentally, a drift rate is sufficiently faster than a diffusion rate. Further, when the position of generation of the photoelectric effect is outside the depletion layer 150 (below the depletion layer 150), the positive holes and electrons are respectively drifted into the back surface of the p-epi 112 and the depletion layer 150 in the Z-axis direction by the acceleration electric field generated by the negative voltage of Vsub.

Described supplementally, in the image sensor 400, the electric line of force Ea described in FIG. 7A is generated between the back surface of the p-epi 112 and the covering portion 113b of the internal electrode layer 113 by the supply of the negative voltage to Vsub. Electrons generated due to the photoelectric effect accompanying the incidence of the reflection modulated light Lb on the image sensor 400 are generated between the covering portion 113b and the back surface of the p-epi 112. Then, there exists there an electric field represented by the electric line of force Ea. The electric field becomes an electric field which accelerates electrons from the back surface of the p-epi 112 toward the covering portion 113b. As a result, the electrons generated due to the photoelectric effect are accelerated and moved to the portion of the depletion layer 150 in the n-type semiconductor region 117, and are accumulated therein.

The electrons moved to the n-type semiconductor region 117 are moved to the n + region 126 through a channel generated between the n-type semiconductor region 117 and the n + region 126 on the back surface side of the oxide film 131 during the on period of the polysilicon film 135. At this time, in the image sensor 400-2 (FIG. 7B), the electrons are accelerated and moved from the n-type semiconductor region 117 to the n + region 126 in the Y-axis direction in response to the electric line of force Eb.

On the other hand, in the image sensor 400b (FIG. 5B), the thickness of the depletion layer 150 is small, and no acceleration electric field exists in the portion other than the depletion layer 150. As a result, when the reflection modulated light Lb is infrared light, a large number of electrons due to the photoelectric effect are generated at a position deeper than the depletion layer 150, and the time for the generated electrons to reach the n-type semiconductor region 117 is prolonged. Further, the number of the electrons reaching the n-type semiconductor region 117 is reduced due to recombination with the positive holes.

The image sensor 400c of FIG. 6B will be described. In the image sensor 400c, the depletion layer 150 is expanded by reducing the impurity concentration of the p-epi 112 to be lower than the impurity concentration of the p-epi 112 of the image sensor 400b. However, it is difficult to generate a directed electric field over the entire depletion layer 150. In particular, the electric field in the depletion layer 150 near the boundary of the depletion layer 150 is often insufficient to cause a drift. Further, a decrease in the impurity concentration of the p-epi 112 leads not only to the depletion layer 150 extending in its depth direction but also expanding in a plane direction (the direction parallel to the XY plane).

As a result, the depletion layers 150 of adjacent sub-pixels Pc overlap in the plane direction. This is because the electrons generated below the depletion layer 150 and in the vicinity of the boundary of the adjacent depletion layer 150 are not diffused into the sub-pixel Pc on which the reflection modulated light Lb which is the cause of their generation is incident, but into the depletion layer 150 of the adjacent sub-pixel Pc, so that they are moved to the n-type semiconductor region 117 of the adjacent sub-pixel Pc. This causes cross talk.

On the other hand, in the image sensor 400, an acceleration electric field (represented by the electric line of force Ea in FIG. 7) which generates each electric line of force Ea exists. Since the electric line of force Ea generated by the voltage difference induce electrons to the n-type semiconductor region 117 of the PD in which the electrons are generated, the crosstalk can be prevented. Further, the electric line of force Eb (FIG. 7B) can increase a discharge speed from the n-type semiconductor region 117 when the polysilicon film 135 as the transfer gate is on.

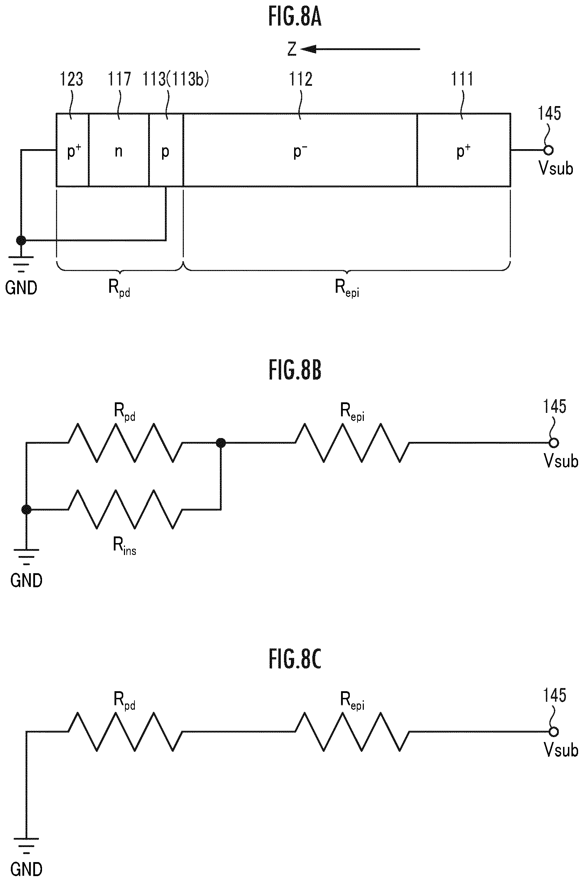

On the other hand, in the image sensor 400, a positive hole current through which a voltage is applied between the channel stopper 115 and the connection point 145 reaches from the connection point 145 to the covering portion 113b through the channel stopper 115 lower in resistance value than the n-type semiconductor region 117. Its effect will be described with reference to the following FIG. 8.

FIG. 8A to FIG. 8C relate to the description of power saving of the image sensor 400. FIG. 8A is a connection diagram of the image sensor 400 and a voltage source, FIG. 8B is an equivalent circuit diagram of FIG. 8A for a positive hole current, and FIG. 8C is an equivalent circuit diagram for a positive hole current when the internal electrode layer 113 is absent.

In FIG. 8A, the image sensor 400 has a layered structure in which from the back surface side to the front surface side (from the negative side to the positive side in the Z-axis direction), the p-sub 111, the p-epi 112, the covering portion 113b of the internal electrode layer 113, the n-type semiconductor region 117, and the p + region 123 are arranged in order. The p-sub 111 and the covering portion 113b become GND (0V in this example), and the back surface of the p-epi 112 becomes a voltage of Vsub.

In the equivalent circuit of the positive hole current in FIG. 8B, a resistance $R_{pd}$ is an equivalent resistance between the n-type semiconductor region 117 and the p-epi 112 which constitute the PD, a resistance $R_{epi}$ is an equivalent resistance of the p-epi 112, and a resistance $R_{ins}$ is an equivalent resistance of the internal electrode layer 113 or the channel stopper 115. Since the internal electrode layer 113 and the channel stopper 115 are in contact with each other, they function as a second potential setting means for supplying GND to the covering portion 113b as one voltage for generating the acceleration electric field Ea. In the second image sensor 400, the resistance Rins is formed in parallel with the resistance $R_{pd}$ by the internal electrode layer 113. Since the resistance value of $R_{ins}$ is sufficiently smaller than the resistance value of $R_{pd}$, a parallel resistance of $R_{pd}$ and $R_{ins}$ becomes approximately Rins. Also, this Rins itself is a sufficiently small value.

When the internal electrode layer 113 is not present (FIG. 8C), the voltage to be applied between GND and Vsub is divided into the resistance $R_{pd}$ and the resistance $R_{epi}$. Usually, since the acceleration electric field Ea (FIG. 7A) is proportional to a voltage drop at $R_{epi}$, it is necessary to increase the voltage applied between GND and Vsub when attempting to sufficiently secure this voltage drop. Accordingly, the power consumption of the image sensor 400 is significantly increased.

On the other hand, in the image sensor 400, a parallel connection circuit of the resistor Rins and the resistor

$R_{pd}$ is formed due to the presence of the internal electrode layer 113 (FIG. 8B). In this case, the resistance Rins becomes a value significantly lower in resistance value than the resistance $R_{pd}$ due to the high impurity concentration of the internal electrode layer 113 or the channel stopper 115. As a result, most of the voltage applied between GND and Vsub contributes as a voltage drop at $R_{epi}$, and hence, the voltage applied between GND and Vsub required to generate the same acceleration electric field can be suppressed low. Therefore, the power consumption of the image sensor 400 can be suppressed.

In a typical example of the impurity concentration of the p-epi 112, an acceptor concentration (impurity concentration) per 1 cm$^3$ ranges from $10^{13}$ to $10^{15}$. Incidentally, the acceptor concentration of the p-epi 112 is preferably low enough to avoid crosstalk between the adjacent sub-pixels Pc.

In the image sensor 400, the p-epi 112 corresponds to a first semiconductor region, the n-type semiconductor region 117 corresponds to a second semiconductor region, and the p + region 123 corresponds to a third semiconductor region. Also, the internal electrode layer 113 corresponds to a fourth semiconductor region, and the n + region 126 corresponds to a fifth semiconductor region. The p-sub 111 or p-epi 112 corresponds to a first potential setting means, and the internal electrode layer 113, the channel stopper 115 or the n-type semiconductor region 117 corresponds to a second potential setting means.

[BSI type semiconductor structure]

FIG. 9A and FIG. 9B relate to an application example of the present invention to a BSI type image sensor 400d. FIG. 9A is a cross-sectional view of the sub-pixel Pc when cut along the vertical direction (Y-axis direction), and FIG. 9B is a cross-sectional view of the sub-pixel Pc when cut along the horizontal direction (X-axis direction). In FIG. 9A and FIG. 9B, illustration of a support substrate (corresponding to the p-sub 111 in the FSI type image sensor 400) is omitted.

In the sub-pixel Pc of the image sensor 400d, the same reference numerals as those attached in FIG. 5A and FIG. 6A denote the same elements as those illustrated in the cross-sectional view of the sub-pixel Pc of the image sensor 400 of FSI in FIG. 5A and FIG. 6A, and their description will be omitted. Only the structural points of difference of the image sensor 400d with respect to the FSI image sensor 400 (FIG. 5A and FIG. 6A) of FSI will be described.

In the BSI image sensor 400d, the orientation of the front and back of the p-epi 112 of the image sensor 400 with respect to the light shield 101 is reversed from that of the FSI image sensor 400, and the back surface side of the p-epi 112 becomes the side of the light receiving surface. Accordingly, the internal electrode layer 113, the channel stopper 115, the n-type semiconductor region 117, the p-type well 119, the p + region 123, and the oxide film 131, etc. formed on the front surface side of the p-epi 112 are disposed on the opposite side to the light shield 101.

A conductive transparent thin film layer 155 is formed on the back surface side (the light shield 101 side) of the p-epi 112. The Vsub supplied to the p-sub 111 in the FSI image sensor 400 is supplied to the conductive transparent thin film layer 155 in the BSI image sensor 400d.

In the image sensor 400d, the p-epi 112 corresponds to a first semiconductor region, the n-type semiconductor region 117 corresponds to a second semiconductor region, and the p + region 123 corresponds to a third semiconductor region. Further, the internal electrode layer 113 corresponds to a fourth semiconductor region, and the n + region 126 corresponds to a fifth semiconductor region. The conductive transparent thin film layer 155 corresponds to a first potential setting means and a semiconductor substrate layer of a first conductivity type. The internal electrode layer 113, the channel stopper 115 or the p + region 123 corresponds to a second potential setting means.

In the image sensor 400d, electrons are generated in the p-epi 112 due to the photoelectric effect by the incidence of the reflection modulated light Lb. Even in the image sensor 400d, similarly to the image sensor 400 of FIG. 5A and FIG. 6A, an acceleration electric field for accelerating the electrons in the p-epi 112 from the back surface of the p-epi 112 to the direction of the covering portion 113b of the internal electrode layer 113 due to the voltage difference between GND and Vsub is generated between the back surface of the p-epi 112 and the covering portion 113b. As a result, the electrons in the p-epi 112 are accelerated and moved to the n-type semiconductor region 117.

Further, even in the image sensor 400d, as with the case of the image sensor 400 of FIG. 8, the positive hole current for the acceleration electric field generation generated by the application of the voltage difference between GND and Vsub flows through the internal electrode layer 113 and the channel stopper 115 low in resistance value. As a result, the power consumption of the image sensor 400d is suppressed despite the generation of the acceleration electric field.

In the image sensor 400d as the BSI, a light shield (also referred to as a "light shielding film") 101 is provided to avoid color mixing of light. However, when there is no possibility of color mixing, the light shield 101 can be omitted from the image sensor 400d.

[Modification]

In the present embodiment, the internal electrode layer 113 has a hanging portion 113a. However, the internal electrode layer 113 may have only the covering portion 113b, and the hanging portion 113a may be omitted. Since the internal electrode layer 113 and the channel stopper 115 are in contact with each other, GND is supplied to the covering portion 113b only via the channel stopper 115 when the hanging portion 113a is omitted.

In the image sensor 400-2 (FIG. 7B) of the present embodiment, the covering portion 113b of the internal electrode layer 113 is in contact with the back surface of the n-type semiconductor region 117 at a half portion of the back surface of the n-type semiconductor region 117 on the channel stopper 115 side in order to generate an electric line of force Eb. However, in order to generate an electric line of force Eb, the back surface of the n-type semiconductor region 117 may be exposed from the covering portion 113b at least in part at the opposite side to the channel stopper 115 and in contact with the p-epi 112.

Description of Reference Numerals

1 ... imaging device, 5 ... control device, 6 ... imaging range, 7 ... ranging object, 53 ... voltage application unit, 111 ... p-sub (semiconductor substrate layer), 112 ... p-epi (first semiconductor region and epitaxial layer), 113 ... internal electrode layer, 113b ... covering portion (fourth semiconductor region), 115 ... channel stopper, 117 ... n-type semiconductor region (second semiconductor region), 123 ... p + region (third semiconductor region), 126 ... n + region (fifth semiconductor region), 400 ... image sensor, PD ... photodiode.

**Claims**

1. An imaging device comprising:

   an image sensor having a plurality of photodiodes; and
   a control device which controls the image sensor,
   wherein each of the plurality of photodiodes comprises:,
   a first semiconductor region of a first conductivity type formed commonly to the plurality of photodiodes;
   a second semiconductor region which is separated from an adjacent photodiode by a channel stopper of the first conductivity type formed commonly to the plurality of photodiodes and is formed on the front surface side of the first semiconductor region, and which is a second conductivity type opposite to the first conductivity type;
   a third semiconductor region of the first conductivity type formed so as to be in contact with the channel stopper and cover the front surface of the second semiconductor region;
   a fourth semiconductor region of the first conductivity type which is interposed between the front surface side of the first semiconductor region and the back surface side of the second semiconductor region, is in contact with the channel stopper, and has a higher impurity concentration than the first semiconductor region;
   a first potential setting means to which a first potential is supplied, the first potential being applied to the back surface of the first semiconductor region; and
   a second potential setting means to which a second potential is supplied, the second potential being applied to the fourth semiconductor region from the front surface side of the channel stopper, and
   wherein the control device supplies a voltage to the first potential setting means and the second potential setting means, the voltage generating an acceleration electric field which causes electric charges of the second conductivity type present in the first semiconductor region to accelerate and move towards the forth semiconductor region.

2. The imaging device according to claim 1, wherein each of the plurality of photodiodes further includes:

   a fifth semiconductor region of the second conductivity type formed, away from the second semiconductor region, on the side opposite to the channel stopper side of the second semiconductor region; and
   a gate formed between the second semiconductor region and the fifth semiconductor region, and
   wherein the back surface of the second semiconductor region is in contact with the fourth semiconductor region on the channel stopper side and the first semiconductor region on the fifth semiconductor region side.

3. The imaging device according to claim 1 or 2, wherein the third semiconductor region is higher in impurity concentration than the channel stopper and the first semiconductor region and is smaller in thickness than the second semiconductor region.

4. The imaging device according to any one of claims 1 to 3, wherein the image sensor has the front surface side of the second semiconductor region as a light receiving side.

5. The imaging device according to any one of claims 1 to 3, wherein the image sensor has the back surface side of the first semiconductor region as a light receiving side.

6. The imaging device according to claim 4 or 5,
wherein the image sensor has a semiconductor substrate layer of a first conductivity type formed commonly to the plurality of photodiodes, and
wherein the first semiconductor region is an epitaxial layer formed on the front surface side of the semiconductor substrate layer.

7. The imaging device according to claim 6, wherein the epitaxial layer has an impurity concentration to avoid the depletion layers of adjacent photodiodes overlapping each other upon generation of the acceleration electric field.

8. The imaging device according to any one of claims 1 to 7, wherein the electric charge of the second conductivity type is an electron.

9. An image sensor comprising:

a first semiconductor region of a first conductivity type formed commonly to the plurality of photodiodes;
a second semiconductor region which is separated from an adjacent photodiode by a channel stopper of the first conductivity type formed commonly to the plurality of photodiodes and is formed on the front surface side of the first semiconductor region, and which is a second conductivity type opposite to the first conductivity type;
a third semiconductor region of the first conductivity type formed so as to be in contact with the channel stopper and cover the front surface of the second semiconductor region;
a fourth semiconductor region of the first conductivity type which is interposed between the front surface side of the first semiconductor region and the back surface side of the second semiconductor region, is in contact with the channel stopper, and has a higher impurity concentration than the first semiconductor region;
a first potential setting means to which a first potential is supplied, the first potential being applied to the back surface of the first semiconductor region; and
a second potential setting means to which a second potential is supplied, the second potential being applied to the fourth semiconductor region from the front surface side of the channel stopper.

10. The image sensor according to claim 9, wherein each of the plurality of photodiodes further comprises:

a fifth semiconductor region of the second conductivity type formed, away from the second semiconductor region, on the side opposite to the channel stopper side of the second semiconductor region; and
a gate formed between the second semiconductor region and the fifth semiconductor region, and
wherein the back surface of the second semiconductor region is in contact with the fourth semiconductor region on the channel stopper side and the first semiconductor region on the fifth semiconductor region side.

# FIG.1

CONTROL DEVICE 5

PHASE DIFFERENCE DETECTION UNIT ~51

DISTANCE MEASUREMENT UNIT ~52

VOLTAGE APPLICATION UNIT ~53

# FIG.2

# FIG.3

# FIG.4

# FIG.5A

# FIG.5B

## FIG.6A

# FIG.6B

# FIG.7A

## FIG.7B

## FIG.8A

Z ←

123  117  113(113b)  112  111  145

| p⁺ | n | p | p⁻ | p⁺ |

Vsub

GND

$R_{pd}$  $R_{epi}$

## FIG.8B

145

$R_{pd}$  $R_{epi}$

$R_{ins}$

Vsub

GND

## FIG.8C

145

$R_{pd}$  $R_{epi}$

Vsub

GND

# FIG.9A

# FIG.9B

<div align="center">**INTERNATIONAL SEARCH REPORT**</div>

| International application No. |
|---|
| PCT/JP2018/034393 |

**A. CLASSIFICATION OF SUBJECT MATTER**

Int.Cl.　H01L27/146(2006.01)i,　G01S7/486(2006.01)i,　G01S17/89(2006.01)i, H01L31/10(2006.01)i,　H04N5/33(2006.01)i,　H04N5/369(2011.01)i, H04N5/374(2011.01)i

According to International Patent Classification (IPC) or to both national classification and IPC

**B. FIELDS SEARCHED**

Minimum documentation searched (classification system followed by classification symbols)

Int.Cl.　H01L27/146,　G01S7/486,　G01S17/89,　H01L31/10,　H04N5/33, H04N5/369, H04N5/374

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2012-29130 A (KONICA MINOLTA OPTO, INC.) 09 February 2012, paragraphs [0023], [0024], [0033]-[0035], fig. 1-18 (Family: none) | 1-10 |
| A | JP 2011-205040 A (BRAINVISION INC.) 13 October 2011, paragraphs [0062]-[0096], fig. 1-11 (Family: none) | 1-10 |
| A | JP 2000-312024 A (CANON INC.) 07 November 2000, paragraphs [0045]-[0074], fig. 1-33 & US 2003/0057431 A1, paragraphs [0129]-[0159], fig. 1-33 & EP 1032049 A2 | 1-10 |

☒ Further documents are listed in the continuation of Box C.　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 November 2018 (27.11.2018) | 11 December 2018 (11.12.2018) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

| | International application No. |
|---|---|
| | PCT/JP2018/034393 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2017-173158 A (STANLEY ELECTRIC CO., LTD.) 28 September 2017, paragraphs [0032]-[0038], fig. 1-7 & US 2017/0276789 A1, paragraphs [0039]-[0045], fig. 1-7 | 1-10 |

Form PCT/ISA/210 (continuation of second sheet) (January 2015)

**REFERENCES CITED IN THE DESCRIPTION**

**Patent documents cited in the description**

- WO 2007026777 A1

- JP P2000312024 A